# EUROPEAN PATENT APPLICATION

(11) **EP 1 737 049 A1**
(43) Date of publication of application: **27.12.2006**
(21) Application number: 05727173.6
(22) Date of filing: 23.03.2005
(51) Int. Cl.: H01L 33/00

(54) **LIGHTING SYSTEM**

(30) Priority: 24.03.2004 JP 2004086667; 30.09.2004 JP 2004285726; 30.11.2004 JP 2004347348
(71) Applicant: TOSHIBA LIGHTING & TECHNOLOGY CORPORATION, Shinagawa-ku, Tokyo 140-8640 (JP)
(72) Inventor: MORIYAMA, T. TOSHIBA LIGHTING & TECHNOLOGY CORP., Tokyo 1408640 (JP); NAKANISHI, A. TOSHIBA LIGHTING & TECHNOLOGY CORP., Tokyo 1408640 (JP); IWAMOTO, M. TOSHIBA LIGHTING & TECHNOLOGY CORP., Tokyo 1408640 (JP); NOGI, Shinji TOSHIBA LIGHTING & TECHNOLOGY CORP., Tokyo 1408640 (JP); OGAWA, Kozo; TOSHIBA LIGHTING & TECHNOLOGY CORP., Tokyo 1408640 (JP); SHIMIZU,Keiichi TOSHIBA LIGHTING & TECHNOLOGY CORP, Tokyo 1408640 (JP); SAITOU, Akiko TOSHIBA LIGHTING & TECHNOLOGY CORP., Tokyo 1408640 (JP); KAWASHIMA,Seiko TOSHIBA LIGHTING & TECHNOLOGCORP., Tokyo 1408640 (JP); SANPEI,Tomohiro TOSHIBA LIGHTING & TECHNOLOGY CORP, Tokyo 1408640 (JP); TODA, Masahiro TOSHIBA LIGHTING & TECHNOLOGY CORP., Tokyo 1408640 (JP)
(74) Representative: Shindler, Nigel
(86) International application number: PCT/JP2005/005232
(87) International publication number: WO 2005/091386

(57) **Abstract**

An illuminating device 11 that is improved in heat radiation property and is suppressed in the occurrence of peeling and warping of a reflector 28, etc., is provided. The reflector 28, having a housing portion 29 that houses a light emitting diode element 21, is disposed on a substrate 22, a visible light converting layer 32 is formed on the housing portion 29, and a lens 33 is disposed on the reflector 28. A circuit pattern 25, the light emitting diode element 21, the reflector 28, the visible light converting layer 32, and the lens 33 are disposed on the substrate 22, and the reflector 28 and the lens 33 are respectively adhered using a same type of adhesive agent 23. The heat radiation property can thus be improved, the peeling and warping of the reflector 28, etc., is suppressed, and accordingly, the optical characteristics of the device can be maintained.

## Description

### TECHNICAL FIELD

The present invention relates to an illuminating device having a light emitting element as a light source.

### BACKGROUND ART

Conventionally, with an illuminating device having, for example, light emitting elements, such as light emitting diode elements that are solid-state light emitting elements, as light sources, a plurality of recessed housing portions are formed on a surface of a substrate, a metal film is formed on an inner surface of each housing portion, a light emitting diode element is disposed in each housing portion, and each housing portion is filled with a transparent resin layer so as to cover the light emitting diode element.

With this illuminating device, because the luminous efficiency of the light emitting diode elements drops when the temperature becomes too high while the light emitting diode elements are lit, a metal substrate, an epoxy resin, or a composite substrate, with which alumina is contained in an epoxy resin, is used as the substrate so that heat is radiated efficiently, or the light emitting diode elements are lit in succession so as to diffuse the heat distribution and thereby prevent temperature rise (see, for example, Patent Document 1).
Patent Document 1: Japanese Laid-Open Patent Publication No. 2002-344031 (pages 4-5, FIGS. 2A-5B)

### DISCLOSURE OF THE INVENTION

### PROBLEMS TO BE SOLVED BY THE INVENTION

Also, although a metal film is formed on the inner surface of each housing portion of the substrate to improve the reflection efficiency, it is difficult to form the metal film uniformly on the inner surface of the housing portion, and when the metal film degrades due to thermal effects and long-term use, the predetermined reflection efficiency cannot be obtained.

Although the use of a reflector, having good heat resistance and good reflection efficiency and being a separate component from the substrate, may be considered, by being made a separate component from the substrate, lowering of the heat radiation property may occur, and the optical characteristics may degrade due to peeling or warping of the reflector from the substrate due to thermal effects and long-term use.

The present invention has been made in view of these points, and an object thereof is to provide an illuminating device that, although having a structure with which a reflector, etc., is disposed on a substrate, enables improvement of the heat radiation property and suppresses the occurrence of peeling and warping of the reflector, etc., to enable maintenance of optical characteristics.

### MEANS FOR SOLVING PROBLEMS

An illuminating device according to claim 1 includes: a substrate; a circuit pattern, formed on the substrate; a light emitting element, electrically connected to the circuit pattern; a reflector, having a housing portion that houses the light emitting element and a reflecting surface on an inner surface of the housing portion and being adhered by an adhesive agent onto the substrate on which the circuit pattern has been formed; a visible light converting layer, disposed on the housing portion of the reflector so as to cover the light emitting element; and a lens, adhered onto the reflector by a same type of adhesive agent as the adhesive agent disposed on the substrate.

By disposing the circuit pattern, the light emitting element, the reflector, the visible light converting layer, and the lens on the substrate, and adhering the reflector and the lens respectively by means of the same type of adhesive agent, the heat radiation property is improved, the occurrence of peeling and warping among the substrate, the reflector, and the lens is suppressed to maintain the optical characteristics, and degradation of the visible light converting layer and the lens is suppressed to improve the light extraction efficiency. Also, because the same type of adhesive agent is used, the lens can be mounted efficiently during manufacture of the substrate. Aluminumor other material of good heat conductance is preferable for the substrate because the heat from the light emitting element can then be conducted and radiated, and by improving the heat radiation property, the problems of degradation of luminous efficiency and variation of color temperature of the light emitting element due to heat effects can be alleviated. The housing portion may be formed not just in the reflector but also at the substrate side. The circuit pattern is, for example, a conductive layer formed on an insulating layer and may be arranged from a single layer or from a plurality of layers.

Claim 2 provides the illuminating device according to claim 1, equipped with a substrate; a circuit pattern, formed on the substrate; a light emitting element, electrically connected to the circuit pattern; a reflector, having a housing portion that houses the light emitting element and a reflector-side fitting portion formed in a periphery of the housing portion and being formed on the substrate on which the circuit pattern has been formed; and a visible light converting layer, disposed on the housing portion of the reflector so as to cover the light emitting element.

Because the circuit pattern is formed on the substrate and the reflector is also formed on the substrate, the heat conductance between the substrate and the reflector is improved, the temperature difference between the substrate and the reflector is reduced, the heat radiation property is improved, and the peeling of the substrate and the reflector is suppressed so that the optical characteristics are maintained. Moreover, the reflector-side fitting portion, formed at the periphery of the housing portion of the reflector that houses the light emitting element, can be used, for example, to mount a lens, and because the light emitting element, the reflector, and the lens are then positioned accurately, the optical characteristics are stabilized. The reflector is made integral to the substrate, for example, by molding it integrally by making a resin flow onto the substrate. The reflector-side fitting portion may be recessed or protruded. The circuit pattern is, for example, a conductive layer formed on an insulating layer and may be arranged from a single layer or from a plurality of layers.

Claim 3 provides the illuminating device according to claim 2, in which the lens in turn has a lens-side fitting portion that fits with the reflector-side fitting portion and is welded in a fitted state onto the reflector.

By fitting and welding the lens-side fitting portion of the lens onto the reflector-side fitting portion of the reflector, the light emitting element, the reflector, and the lens are positioned accurately so that the optical characteristics are stabilized and the lens is fixed reliably onto the reflector. "Welding" refers to laser welding, ultrasonic welding, and other means of affixing upon melting portions at which the substrate and the lens are bonded together.

Claim 4 provides the illuminating device according to the claim 2 or 3, with the substrate having a plurality of light emitting element positioning portions, at which a plurality of light emitting elements are positioned, and anchoring-portion-provided penetrating holes, formed between the plurality of light emitting element positioning portions, and with the reflector having reflecting portions, reflecting light from the light emitting elements and being formed on the substrate, and supporting portions, formed integral to the reflecting portions by making a resin flow into the anchoring-portion-provided penetrating holes of the substrate.

By the reflector being supported on the substrate by the supporting portions formed by making the resin flow into the anchoring-portion-provided penetrating holes of the substrate, the peeling of the reflector is suppressed and the optical characteristics are maintained more reliably. The anchoring-portion-provided penetrating holes are formed between the light emitting element positioning portions and are preferably formed at substantially central portions between the light emitting element positioning portions because the reflector supporting portions that are positioned at the anchoring-portion-provided penetrating holes can then be supported uniformly as a whole. As long as the supporting portions of the reflector are prevented from becoming removed from the substrate, the anchoring-portion-provided penetrating holes do not have to be formed between the light emitting element positioning portions.

Claim 5 provides the illuminating device according to any one of claims 1 to 4, in which the housing portion satisfies a relationship, θ = tan⁻¹{h/(A-B) }>45°, where A is an aperture diameter at the lens side, B is an aperture diameter at the substrate side, h is a depth of the housing portion, and θ is an angle of spread of the housing portion from the substrate side to the lens side.

Because the housing portion satisfies the relationship, θ = tan⁻¹{h/ (A-B) }>45°, where A is the aperture diameter at the lens side, B is the aperture diameter at the substrate side, h is the depth of the housing portion, and θ is the angle of spread of the housing portion from the substrate side to the lens side, the efficiency of light extraction from the housing portion is optimized and the design of the housing portion is facilitated regardless of the dimensions and type of the light emitting element.

Claim 6 provides the illuminating device according to any one of claims 1 to 5, in which the visible light converting layer is formed by dispersing a visible light converting substance in one type of resin among a silicone resin, an epoxy resin, and a modified epoxy resin.

With the visible light converting layer, because the visible light converting substance is dispersed in one type of resin among a silicone resin, an epoxy resin, and a modified epoxy resin, light of the visible range can be extracted readily.

Claim 7 provides the illuminating device according to any one of claims 1 to 5, in which two resin layers are formed on the housing portion of the reflector so as to cover the light emitting element, the visible light converting layer is the upper layer of the two resin layers and is formed by making a visible light converting substance sediment in one type of resin among a silicone resin, an epoxy resin, and a modified epoxy resin.

Because of the two resin layers that are formed on the housing portion of the reflector so as to cover the light emitting element, the upper layer is the visible light converting layer, in which the visible light converting substance is sedimented in one type of resin among a silicone resin, an epoxy resin, and a modified epoxy resin, a large amount of light of the visible range can be extracted readily and the light extraction efficiency is improved.

### EFFECTS OF THE INVENTION

With the illuminating device according to claim 1, because the circuit pattern, the light emitting element, the reflector, the visible light converting layer, and the lens are disposed on the substrate and the reflector and the lens are respectively adhered by the same type of adhesive agent, the heat radiation property can be improved, the occurrence of peeling and warping among the substrate, the reflector, and the lens can be suppressed to enable the optical characteristics to be maintained, and degradation of the visible light converting layer and the lens can be suppressed to enable improvement of the light extraction efficiency. Also, because the same type of adhesive agent is used, the lens can be mounted efficiently during manufacture of the substrate.

With the illuminating device according to claim 2, because the circuit pattern is formed on the substrate and the reflector is also formed on the substrate, the heat conductance between the substrate and the reflector is improved, the temperature difference between the substrate and the reflector can be reduced, the heat radiation property can be improved, the peeling of the substrate and the reflector can be suppressed to enable the optical characteristics to be maintained, and moreover, because the reflector-side fitting portion, formed at the periphery of the housing portion of the reflector that houses the light emitting element, can be used, for example, to mount a lens, the light emitting element, the reflector, and the lens can be positioned accurately to enable the optical characteristics to be stabilized, and the lens can be fixed reliably onto the reflector.

With the illuminating device according to the claim 3, because, in addition to providing the effects of the illuminating device according to claim 2, the lens-side fitting portion of the lens is fitted and welded onto the reflector-side fitting portion of the reflector, the light emitting element, the reflector, and the lens can be positioned accurately to enable the optical characteristics to be stabilized and the lens can be fixed reliably onto the reflector.

With the illuminating device according to claim 4, because, in addition to providing the effects of the illuminating device according to claim 2 or 3, the reflector can be supported on the substrate by the supporting portions that are formed by making the resin flow into the anchoring-portion-provided penetrating holes of the substrate, the peeling of the reflector can be suppressed more reliably to enable the optical characteristics to be maintained.

With the illuminating device according to claim 5, because, in addition to providing the effects of the illuminating device according to any one of the claims 1 to 4, the housing portion satisfies the relationship, θ = tan⁻¹{h/ (A-B) }>45°, where A is the aperture diameter at the lens side, B is the aperture diameter at the substrate side, h is the depth of the housing portion, and θ is the angle of spread of the housing portion from the substrate side to the lens side, the efficiency of light extraction from the housing portion can be optimized and the design of the housing portion can be facilitated regardless of the dimensions and type of the light emitting element.

With the illuminating device according to the claim 6, because, in addition toproviding the effects of the illuminating device according to any one of the claims 1 to 5, the visible light converting layer has the visible light converting substance dispersed in one type of resin among a silicone resin, an epoxy resin, and a modified epoxy resin, light of the visible range can be extracted readily.

With the illuminating device according to claim 7, because, in addition to providing the effects of the illuminating device according to any one of claims 1 to 5, the upper resin layer of the two-layer resin layer formed on the housing portion of the reflector so as to cover the light emitting element is the visible light converting layer, in which the visible light converting substance is sedimented in one type of resin among a silicone resin, an epoxy resin, and a modified epoxy resin, a large amount of light of the visible range can be extracted readily and the light extraction efficiency can be improved.

### BRIEF DESCRIPTION OF THE DRAWINGS

FIG. 1 is a sectional view of a light emitting module of an illuminating device according to a first embodiment of the present invention;
FIG. 2 is a front view of the same light emitting module;
FIG. 3 is a front view of the same illuminating device;
FIG. 4 is an explanatory diagram of examples of combinations of materials of the same light emitting module;
FIG. 5 is a sectional view of a mounting structure of a light emitting diode element of an illuminating device according to a second embodiment of the present invention;
FIG. 6 is a sectional view of a mounting structure of a light emitting diode element of an illuminating device according to a third embodiment of the present invention;
FIG. 7 is a sectional view of a light emitting module of an illuminating device according to a fourth embodiment of the present invention;
FIG. 8 is a sectional view of an illuminating device according to a fifth embodiment of the present invention;
FIG. 9 is a sectional view of an illuminating device according to a sixth embodiment of the present invention;
FIG. 10 is a front view of a light emitting module of an illuminating device according to a seventh embodiment of the present invention;
FIG. 11 is a sectional view of the same light emitting module;
FIG. 12 is a sectional view of a light emitting module of an illuminating device according to an eighth embodiment of the present invention;
FIG. 13 is a sectional view of a portion of a light emitting module of an illuminating device according to a ninth embodiment of the present invention;
FIG. 14 is a plan view of a substrate of the same illuminating device;
FIG. 15 is a sectional view of the light emitting module and a main device body of the same illuminating device; and
FIG. 16 is a plan view of the light emitting modules and the main device body of the same illuminating device.

### DESCRIPTION OF REFERENCE NUMERALS

- 11: illuminating device
- 21: light emitting diode element as a light emitting element
- 22: substrate
- 23: adhesive agent
- 25: circuit pattern
- 28: reflector
- 29: housing portion
- 30: reflecting surface
- 32: visible light converting layer
- 33: lens
- 40, 41: resin layer
- 62: anchoring-portion-provided penetrating hole
- 63: anchoring portion
- 64: reflecting portion
- 65: supporting portion
- 71: illuminating device
- 81: substrate
- 82: light emitting diode element as a light emitting element
- 90: circuit pattern
- 83: reflector
- 98: housing portion
- 99: reflecting surface
- 100: visible light converting layer
- 101: reflector-side fitting portion
- 103: lens
- 110: lens-side fitting portion

### BEST MODES FOR CARRYING OUT THE INVENTION

Embodiments of the present invention shall now be described with reference to the drawings.

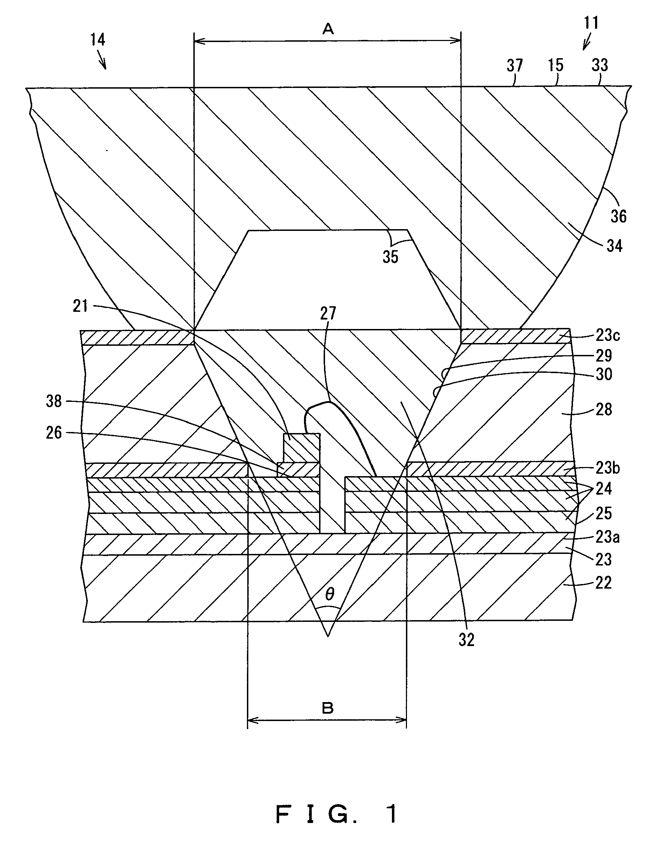

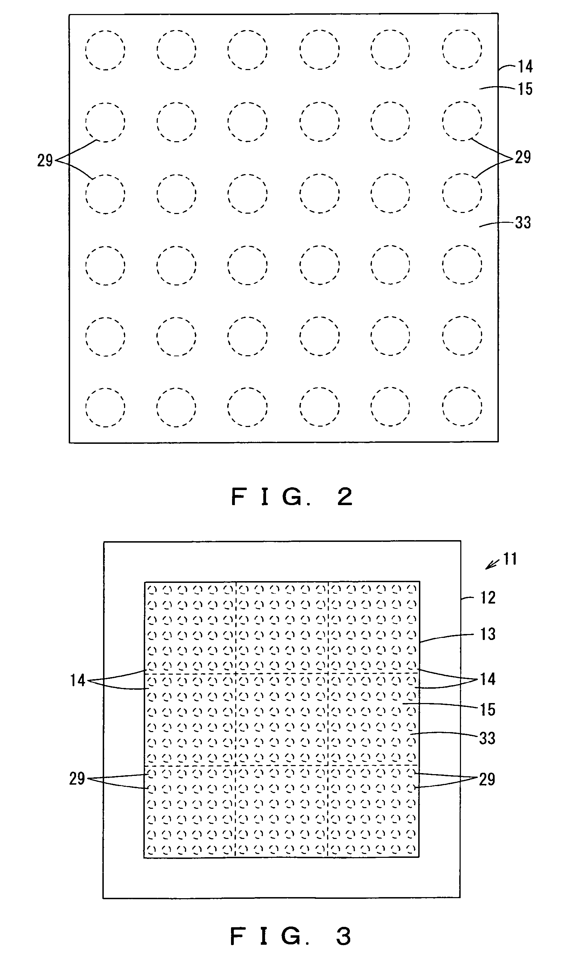

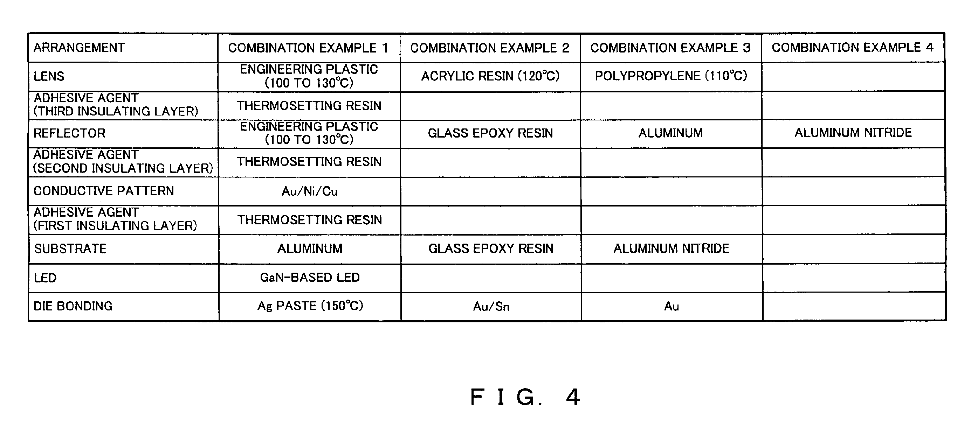

FIG. 1 to FIG. 4 show a first embodiment, with FIG. 1 being a sectional view of a light emitting module of an illuminating device, FIG. 2 being a front view of the light emitting module, FIG. 3 being a front view of the illuminating device, and FIG. 4 being an explanatory diagram of examples of combinations of materials of the light emitting module.

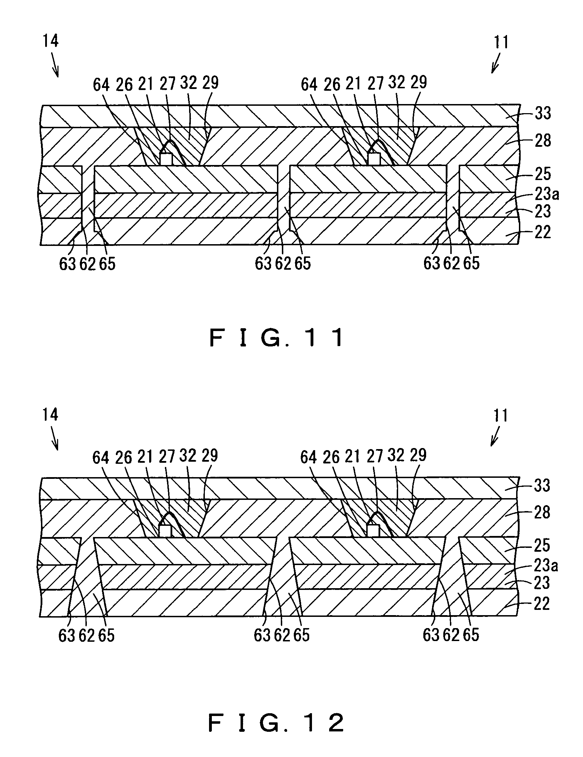

In FIG. 3, 11 is the illuminating device, and this illuminating device 11 has a thinly-formed, rectangular main device body 12, a rectangular opening 13 is formed on a surface of this main device body 12, a plurality of rectangular light emitting modules 14 are arrayed in matrix form inside the opening 13, and a light emitting surface 15 is formed by the plurality of light emitting modules 14.

As shown in FIG. 1, each light emitting module 14 has, as light emitting elements, chip type light emitting diode elements 21, which are solid-state light emitting elements, and the plurality of light emitting diode elements 21 are disposed in matrix form on one surface side, that is, the top surface side of a substrate 22, formed, for example, of a glass epoxy resin, aluminum, aluminum nitride, or other material of high heat conductance.

On the one surface of substrate 22, an adhesive agent 23 is coated as an insulating layer that is a thermosetting resin or a thermoplastic resin having an elastic modulus lower than epoxy resins and higher than engineering plastics and having an insulating property and a heat conducting property, and an electrically conductive layer 24 of, for example, copper, gold, or nickel, etc., is adhered and positioned via the first insulating layer 23a formed from the adhesive agent 23. A circuit pattern 25 is formed by the electrically conductive layer 24, and light emitting element positioning portions 26, onto which the light emitting diode elements 21 are mounted, are formed in matrix from on the circuit pattern 25. At each light emitting element positioning portion 26, one electrode of each light emitting diode element 21 is connected by die bonding by a silver paste that serves as a connecting layer 38 onto one of the pole patterns of the circuit pattern 25, and the other electrode is connected by wire bonding by a wire 27 to the other pole pattern of the circuit pattern 25.

On the one surface side of the substrate 22, a reflector 28, formed of a glass epoxy resin, an engineering plastic, aluminum, aluminum nitride, or other material having high heat resistance and high reflecting characteristics, is adhered and positioned via a second insulating layer 23b, formed of adhesive agent 23 of a same type as that of the first insulating layer 23a. In correspondence to the respective light emitting element positioning portions 26, a plurality of housing portions 29, in which the light emitting diode elements 21 are respectively positioned in a housed state, are opened and formed in the reflector 28. With each housing portion 29, an aperture diameter A, at a lens 33 side, that is, a top surface side at the side opposite the substrate 22 side, is greater than an aperture diameter B at the substrate 22 side, that is, a rear surface side, and each housing portion 29 thus spreads open from the substrate 22 side to a lens 33 side, that is, from the rear surface side to the top surface side and has formed thereon a reflecting surface 30 that is inclined so as to face the interior of the housing portion 29. As the reflecting surface 30, a reflecting film of white titanium oxide, copper, nickel, aluminum, or other material of high reflectance may be formed.

The shape of each housing portion 29 satisfies a relationship, θ = tan⁻¹{h/ (A-B)}>45°, where A is the aperture diameter at the lens 33 side that is opposite the substrate 22 side, B is the aperture diameter at the substrate 22 side, h is a depth of the housing portion 29, and θ is an angle of spread of the housing portion 29 from the substrate 22 side to the lens 33 side.

In each housing portion 29, a visible light converting layer 32 is fillingly formed so as to cover the light emitting diode element 21. This visible light converting layer 32 is formed by dispersing a visible light converting substance, such as a phosphor that converts ultraviolet rays from the light emitting diode element 21 into visible light, in, for example, a silicone resin, an epoxy resin, or a modified epoxy resin.

At the top surface side of the reflector 28, the lens 33, formed, for example, of polycarbonate, an acrylic resin, or other light transmitting resin, is disposed via a third insulating layer 23c formed of the adhesive agent 23 of the same type as that of the first insulating layer 23a and the second insulating layer 23b. If a thermosetting resin is used in the substrate 22, the same type of thermosetting resin is used in the material of the lens 33. If a thermoplastic resin is used in the substrate 22, the same type of thermoplastic resin is used in the material of the lens 33.

The lens 33 has lens portions 34 that are formed to lens shapes in correspondence to the respective light emitting diode elements 21, and with each lens portion 34, a recessed incidence surface 35, which opposes the housing portion 29 and onto which light is made incident, a reflecting surface 36, which reflects light made incident onto the incidence surface 35, and an exit surface 37, from which the light made incident onto the incidence surface 35 and the light reflected by the reflecting surface 36 exit, are formed. The light emitting surface 15, common to the light emitting modules 14, is formed from the light emitting surfaces 37 of the plurality of lens portions 34.

Also, in FIG. 4 are indicated combination examples 1, 2, 3, and 4 of combinations of the substrate 22, the adhesive agent 23 (the first insulating layer 23a, the second insulating layer 23b, and the third insulating layer 23c), the electrically conductive layer 24, the reflector 28, and the lens 33. For the combination examples 2, 3, and 4, just the combinations of materials that differ from that of the combination example 1 are shown.

By making the light emitting diode elements 21 become lit, the light from each light emitting diode element 21 is made incident on the visible light converting layer 32, and the light made incident on the visible light converting layer 32 is made directly incident on the incidence surface 35 of the lens 33 from the housing portion 29 or is made incident on the incidence surface 35 of the lens 33 from the housing portion 29 upon being reflected by the reflecting surface 30 or the one surface of the substrate 22, and exits, via the lens 33, from the exit surface 37, that is, the light emitting surface 15.

During lighting of the light emitting diode elements 21, the heat generated by the light emitting diode elements 21 is transferred to the substrate 22, the electrically conductive layer 24, the reflector 28, the lens 33, etc., and thermal expansion differences arise due to the material differences of the substrate 22, the electrically conductive layer 24, the reflector 28, and the lens 33. Because the substrate 22, the electrically conductive layer 24, the reflector 28, and the lens 33 are adhered and fixed together using the same type of adhesive agent 23, which is a thermosetting resin or a thermoplastic resin having an elastic modulus lower than epoxy resins and higher than engineering plastics, the thermal expansion differences can be absorbed, the occurrence of peeling can be suppressed, and the adhesively fixed state can be maintained reliably.

Also, because the electrically conductive layer 24, the light emitting diode elements 21, the reflector 28, the visible light converting layers 32, and the lens 33 are disposed on the substrate 22 and the reflector 28 and the lens 33 are respectively adhered using the same type of adhesive agent 23, the radiation of heat from the substrate 22 can be improved, the occurrence of peeling and warping among the substrate 22, the reflector 28, and the lens 33 can be suppressed to enable the optical characteristics to be maintained, and degradation of the visible light converting layers 32, the lens 33, etc., can be suppressed to enable improvement of the light extraction efficiency. Also, because the same type of adhesive agent 23 is used, the lens 33 can be mounted efficiently during manufacture of the substrate.

Also, because the shape of each housing portion 29 is defined to satisfy the relationship, θ = tan⁻¹{h/(A-B)}>45°, where A is the aperture diameter at the lens 33 side, B is the aperture diameter at the substrate 22 side, h is the depth of the housing portion 29, and θ is the angle of spread from the substrate 22 side to the lens 33 side, the efficiency of light extraction from the housing portion 29 can be optimized and the design of the housing portion 29 can be facilitated regardless of the dimensions and type of the light emitting diode elements 21.

Also, because the visible light converting layers 32 are disposed on the housing portions 29 to cover the light emitting diode elements 21, for example, ultraviolet rays canbe converted to visible light to enable more light in the visible range to be extracted and the light extraction efficiency to be improved. Each visible light converting layer 32 has a visible light converting substance dispersed in one type of resin among a silicone resin, an epoxy resin, and a modified epoxy resin and can be formed readily.

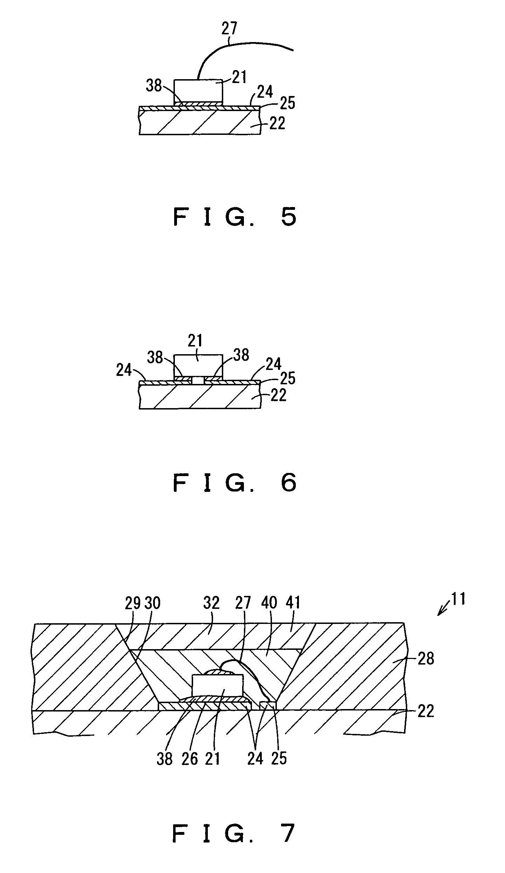

As a method of disposing each light emitting diode element 21, one of the electrodes of the light emitting diode element 21 may be connected to a gold/tin connecting layer 38 on a tin conductive layer 24 as in a second embodiment shown in FIG. 5.

Also, as a method of disposing the light emitting diode element 21, in a case of surface mounting the light emitting diode element 21, the respective electrodes of the light emitting diode element 21 may be connected by gold bump connecting layers 38 to the respective pole patterns of the circuit pattern 25 of tin conductive layers 24 as in a third embodiment shown in FIG. 6.

A fourth embodiment is shown in FIG. 7. FIG. 7 is a sectional view of a light emitting module of an illuminating device. The basic arrangement of the illuminating device 11 is the same as that of the first embodiment.

One of the electrodes of the light emitting diode element 21 is connected by die bonding by a silver paste connecting layer 38 to the circuit pattern 25 of the conductive layers 24 formed on the light emitting element positioning portion 26, which is a bottom portion of the housing portion 29, and the other electrode of the light emitting diode element 21 is connected by wire bonding by a wire 27.

In the housing portion 29 are formed two transparent resin layers 40,41 that cover the light emitting diode element 21. The lower resin layer 40 that directly covers the light emitting diode element 21 is formed, for example, of a silicone resin, which is highly resistant against ultraviolet rays, has elasticity, and has a diffusing agent dispersed therein that diffuses the visible light and ultraviolet rays from the light emitting diode element 21. The upper resin layer 41 is formed of a silicone resin, an epoxy resin, or a modified epoxy resin, etc., and is arranged as the visible light converting layer 32, in which is sedimented a visible light converting substance, such as a phosphor that converts the ultraviolet rays from the light emitting diode element 21 into visible light.

Because, of the two resin layers 40,41 that cover the light emitting diode element 21 disposed in the housing portion 29, the upper resin layer 41 is the visible light converting layer 32 having the visible light converting substance sedimented therein, a large amount of light of the visible range can be extracted and the light extraction efficiency can be improved.

Because the visible light converting substance is sedimented, the visible light and ultraviolet rays illuminated from the lower resin layer 40 can be illuminated efficiently onto the visible light converting substance and the thickness of the upper resin layer 41 can be set arbitrarily.

Because the diffusing agent is mixed into the lower resin layer 40, the light radiated from the light emitting diode element 21 can be illuminated uniformly onto a boundary surface with respect to the upper resin layer 41.

If the wire 27 is positioned at the boundary surface of the two resin layers 40,41, this becomes a cause of color non-uniformity. The height position of the wire 27 is determined by the height of the light emitting diode element 21, the hardness and workability of the wire 27, etc. Thus, if the height of the light emitting diode element 21 is approximately 75µm and the height from the bottom surface of the housing portion 29 to the highest point of the wire 27 is 200µm, preferably the lower resin layer 40 is made 250µm in thickness and the upper resin layer 41 is made 750µm in thickness, and in a case where the height from the bottom surface of the housing portion 29 to the highest point of the wire 27 is 425µm, preferably the lower resin layer 40 is made 475µm in thickness and the upper resin layer 41 is made 525µm in thickness. The depth of the housing portion is optimally 800 to 1200µm and is more preferably 1000µm.

If nothing is mixed into the lower resin layer 40, the attenuation of the light radiated from the light emitting diode element 21 can be minimized.

Inorganic nanoparticles, which are a filler of no more than 10⁻⁹m, are dispersed in the lower resin layer 40. As the nanoparticles, nanosilica, etc. , which is controlled to a narrow particle size distribution of no more than 50nm, is used, with the weight composition being 0.1% to 60% and the visible light transmittance being 50% to 90%.

By thus dispersing inorganic nanoparticles in the resin layer 40, the conductance of heat to the substrate 22, the reflector 28, the lens 33, etc., is improved and the heat radiation property can be improved.

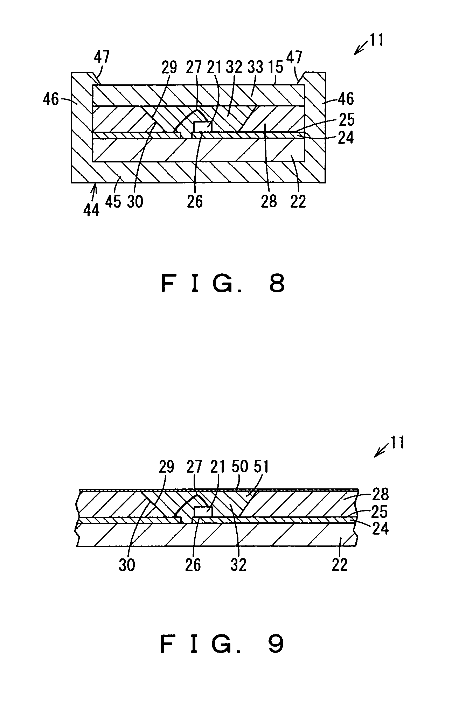

A fifth embodiment is shown in FIG. 8. FIG. 8 is a sectional view of an illuminating device. The basic arrangement of the illuminating device 11 is the same as that of the first embodiment.

A case 44, which is made of aluminum or other metal, positions and fixes the substrate 22, the reflector 28, and the lens 33, and radiates heat, is provided. In this case 44, a base portion 45 that is put in plane contact with the substrate 22 is formed, side surface portions 46 that hold both side surfaces of the substrate 22, the reflector 28, and the lens 33 are erected from both sides of the base portion 45, and at the tips of the side surface portions 46 are formed claw portions 47 that engage with the lens 33 and, together with the base portion 45, hold the substrate 22, the reflector 28, and the lens 33 sandwichingly.

The substrate 22, the reflector 28, and the lens 33 can be positioned and fixed and the heat radiation property can be improved by the case 44.

Also, by providing unillustrated concavo-convex engagement portions for male-female engagements of the substrate 22 and the reflector 28 and of the reflector 28 and the lens 33, positional relationships of the substrate 22 and the reflector 28 and of the reflector 28 and the lens 33 can be kept constant at all times and the optical characteristics can be stabilized.

A sixth embodiment is shown in FIG. 9. FIG. 9 is a sectional view of an illuminating device. The basic arrangement of the illuminating device 11 is the same as that of the first embodiment.

A resin sheet 50, with a thickness of approximately 0.5mm and containing a phosphor, is adhered onto a top surface side of the light emitting module 14, that is, onto a top surface of the reflector 28 in the present embodiment.

As a method of attaching this resin sheet 50, the resin sheet 50 is attached with the housing portion 29 being filled with a resin layer 51 up to an opening plane of the housing portion 29, and the resin sheet 50 is adhered by means of the resin layer 51. Or, as another method, the adhesion surface of the resin sheet 50 is put in a semi-hardened state, this surface is attached to the top surface of the reflector 28, and heat is applied to adhere the resin sheet 50. By either method, the resin sheet 50 can be adhered readily without using an adhesive agent.

Also, by making the resin sheet 50 and the resin layer 51 substantially the same in refractive index, the light extraction efficiency can be improved.

Also, if an adhesive agent is to be used to attach the resin sheet 50, the film thickness of the adhesive agent is made no more than 1/4 the thickness of the resin sheet 50. If the film thickness of the adhesive agent is made thicker than 1/4 the thickness of the resin sheet 50, the stress of the adhesive agent becomes large and peeling and deformation of the resin sheet 50 occur readily.

Although in the embodiments described above, the illuminating device 11 is arranged by arraying the plurality of light emitting modules 14 in array form, the illuminating device 11 may instead be arranged from a single light emitting module in which the light emitting modules 14 are formed integrally.

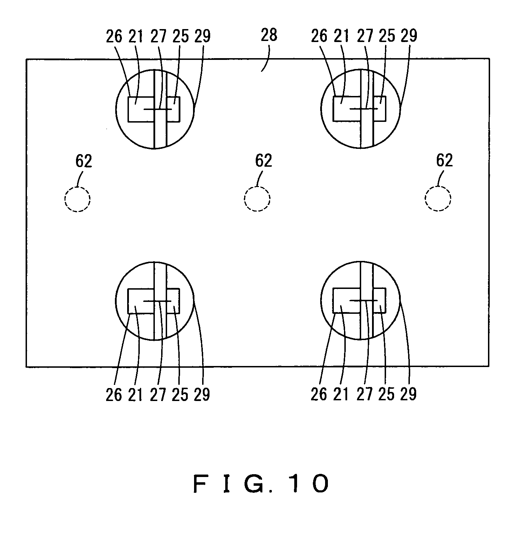

A seventh embodiment is shown in FIG. 10 and FIG. 11. FIG. 10 is a front view of a light emitting module and FIG. 11 is a sectional view of the light emitting module. The basic arrangement of the illuminating device 11 is the same as that of the first embodiment.

A substrate 61 is formed from the substrate 22, which is made, for example, of metal, the first insulating layer 23a, disposed on the substrate 22, the circuit pattern 25, disposed on the first insulating layer 23a, etc.

The substrate 61 has the plurality of light emitting element positioning portions 26 formed at equal intervals in the circuit pattern 25 for positioning the light emitting diode elements 21 and has anchoring-portion-provided penetrating holes 62 that are formed to pass through the substrate 22 at central portions between adjacent light emitting element positioning portions 26. Each of the anchoring-portion-provided penetrating holes 62 has an anchoring portion 63, which is formed in a spreading manner and becomes wider in opening width at an end portion at the other surface side of the substrate 22, which is the side opposite the one surface side of the substrate 22 whereat the reflector 28, the lens 33, etc., are positioned.

The reflector 28 is disposed on the substrate 61 and has reflecting portions 64, which are disposed at the one surface side of the substrate 22 and reflect the light from the light emitting diode elements 21, and supporting portions 65, that are disposed so as to pass through the anchoring-portion-provided penetrating holes 62.

The reflecting portions 64 and the supporting portions 65 of the reflector 28 are formed integrally, and because by making a resin flow into the anchoring-portion-provided penetrating holes 62, the resin enters into the anchoring portions 63, the supporting portions 65 fit with the anchoring portions 63 to prevent the reflector 28 from becoming removed from the substrate 22.

During lighting of the light emitting diode elements 21, the heat generated by the light emitting diode elements 21 is transferred to the substrate 22, the reflector 28, the lens 33, etc., and thermal expansion differences arise due to the material differences of the substrate 22, the reflector 28, and the lens 33. In this process, because the reflector 28 is supported on the substrate 61 by the supporting positions 65 that are disposed so as to pass through the anchoring-portion-provided penetrating holes 62, the heat radiation property can be improved and the occurrence of peeling and warping of the reflector 28 can be suppressed to enable the optical characteristics to be maintained.

The anchoring-portion-provided penetrating holes 62 are preferably formed at central portions between the light emitting element positioning portions 26 because the supporting portions 65 of the reflector 28 that are disposed in the anchoring-portion-provided penetrating holes 62 can then be supported uniformly as a whole. The anchoring-portion-provided penetrating holes 62 do not have to be formed between the light emitting element positioning portions 26.

The anchoring-portion-provided penetrating holes 62 may be arranged as tapered holes, each having a tapered shape that spreads towards the other surface side of the substrate 22, which is the side opposite the one surface side of the substrate 22 at which the reflector 28, the lens 33, etc., are disposed, as in an eighth embodiment shown in FIG. 12. In this case, the anchoring portion 63 is formed by the tapered hole itself. The tapered hole provides an action of making the resin flow in smoothly.

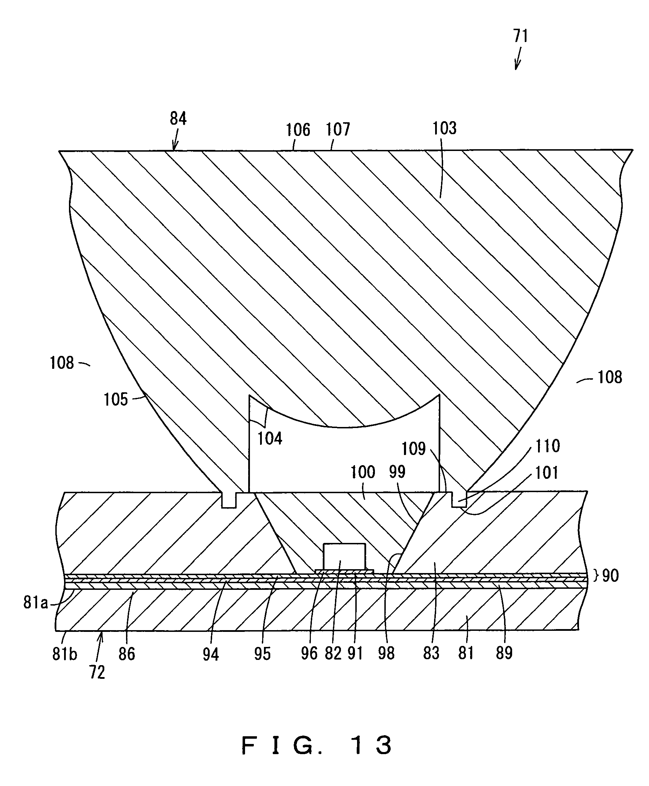

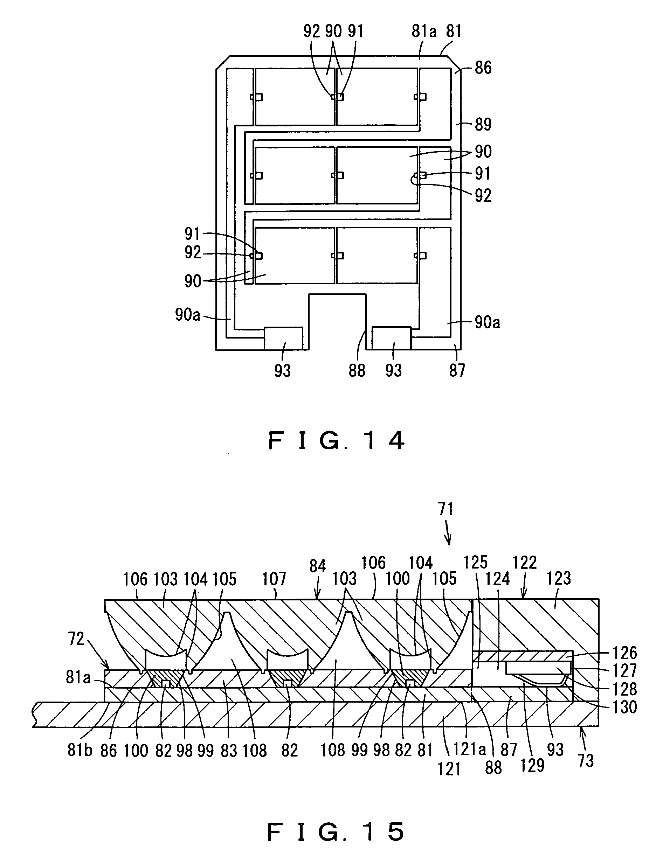

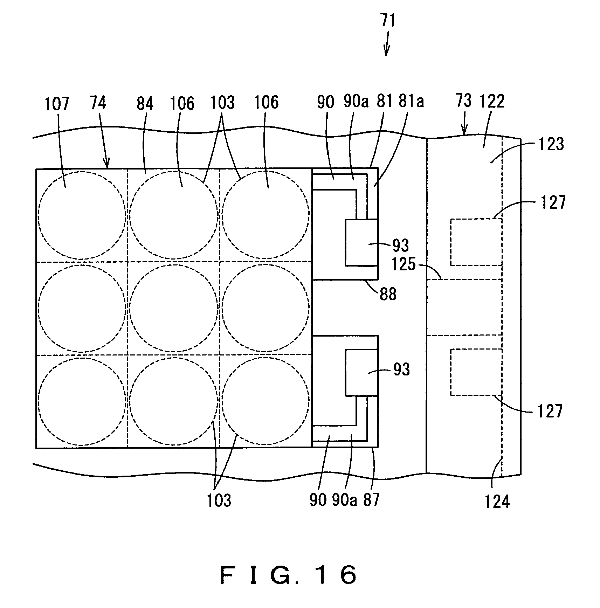

FIG. 13 to FIG. 16 show a ninth embodiment. FIG. 13 is a sectional view of a portion of a light emitting module of an illuminating device, FIG. 14 is a plan view of a substrate of the illuminating device, FIG. 15 is a sectional view of the light emitting module and a main device body of the illuminating device, and FIG. 16 is a plan view of the light emitting modules and the main device body of the illuminating device.

As shown in FIG. 15 and FIG. 16, the illuminating device 71 has a plurality of the light emitting modules 72 and has a main device body 73 onto which these light emitting modules 72 are mounted.

Each light emitting module 72 includes a substrate 81, a plurality of light emitting diode elements 82, which are solid-state light emitting elements that serve as the light emitting elements and are positioned on one surface 81a of the substrate 81, a reflector 83 that reflects the light of the respective light emitting diode elements 82, and a lens body 84 that adjusts the light of the respective light emitting diode elements 82. In the present embodiment, three light emitting diode elements 82 are aligned at equal intervals in each of longitudinal and lateral directions of the substrate 81 and are thus aligned in a matrix form.

The substrate 81 is preferably formed of a material of high heat conductance, such as aluminum, or is formed of material of high heat conductance, such as a glass epoxy resin, an engineering plastic, or aluminum nitride. The substrate 81 includes a light emitting element positioning portion 86, in which the plurality of light emitting diode elements 82 are disposed, and an inserted portion 87 that protrudes outward from one edge of this light emitting element positioning portion 86, and a rectangular fitting groove 88 is formed at a center of the inserted portion 87.

As shown in FIG. 13 and FIG. 14, on the one surface 81a of the substrate 81, an insulating layer 89, the modulus of elongation of which varies within 2000MPa according to temperature and the thickness of which is no more than 75µm, is formed of an adhesive agent that is a thermosetting resin or a thermoplastic resin, such as a polyimide resin or an epoxy resin, and an inorganic metal powder or other material having an insulating property and heat conductance. If the thickness of the insulating layer 89 is thicker than 75µm, good heat conductance cannot be provided between the substrate 81 and the reflector 83, and although the thinner the insulating layer 89, the better the heat conductance, the lower limit of the thickness of the insulating layer 89 is defined by the value at which the insulating property can still be provided.

Circuit patterns 90 are formed on the insulating layer 89 of the substrate 81, and the respective light emitting diode elements 82 are electrically connected and mechanically fixed to the circuit patterns 90. The circuit patterns 90 are respectively partitioned according to light emitting element positioning portions 91 of the respective light emitting diode elements 82 and are formed to patterns enabling the plurality of the light emitting diode elements 82 to be connected in series. Of adjacent circuit patterns 90, a light emitting diode element 82 is mounted onto the light emitting element positioning portion 91 of one of the circuit patterns 90 and one of the terminals of this light emitting diode element 82 is electrically connected and mechanically fixed to this light emitting element positioning portion 91, and the other electrode of the light emitting diode element 82 is electrically connected by wire bonding to a connection position 92 of the other circuit pattern 90.

Circuit patterns 90a that are positioned at the respective ends of a serially connected plurality of light emitting diode elements 82 are respectively extended to the inserted portion 87, and on the respective circuit patterns 90a at the inserted portion 87 are formed receiving portions 93, which are electrodes. The receiving portions 93 are thus formed on the one surface 81a of the substrate 81 on which the light emitting diode elements 82 are disposed.

The circuit pattern 90 has a first metal layer 94, which is formed of copper foil or other material of excellent electrical conductance and heat conductance on the insulating layer 89, a second metal layer 95, which is a nickel plating layer or other highly reflecting metal layer that is formed on the first metal layer 94, and a cooper plating layer or other third metal layer 96 of excellent electrical conductance and heat conductance that is formed on the second metal layer 95, and the light emitting element positioning portions 91, the connection positions 92, and the receiving portions 93 are respectively formed from the third metal layer 96.

As shown in FIG. 13 and FIG. 15, the reflector 83 is formed to be in direct close contact with the light emitting element positioning portion 86 of the one surface 81a of the substrate 81 and is made integral to the substrate 81, for example, by making polybutylene terephthalate (PBT), polycarbonate, or other resin material of high heat resistance and high reflecting property flow onto rough surfaces of the light emitting element positioning portion 86 at the one surface 81a of the substrate 81 and molding the resin.

In the reflector 83, a plurality of housing portions 98, which are recessed portions that house the respective light emitting diode elements 82, are formed according to the positions of the respective light emitting diode elements 82, and in each housing portion 98 is formed a reflecting surface 99 that reflects light and spreads toward the lens body 84 side that is opposite the substrate 81 side. In each housing portion 98, a visible light converting layer 100 is fillingly formed so as to cover the light emitting diode element 82, and this visible light converting layer 100 is formed by dispersing a visible light converting substance, such as a phosphor that converts ultraviolet rays from the light emitting diode element into visible light, in, for example, a silicone resin, an epoxy resin, or a modified epoxy resin.

On the surface of the reflector 83 at the side opposite the substrate 81 side, groove like reflector-side fitting portions 101 are formed in a ring-like manner at positions at peripheries of the respective housing portions 98 that are slightly separated to the outer side from the opening edges of the housing portions 98.

As shown in FIG. 13, FIG. 15, and FIG. 16, the lens body 84 is positioned at the light emitting element positioning portion 86 of the one surface 81a of the substrate 81 and is formed, for example, of polycarbonate, acrylic resin, or other resin material with a light transmitting property. This lens body 84 has a plurality of lenses 103 that are positioned in correspondence to the positions of the respective light emitting diode elements 82, and on each lens 103 are formed a concave incidence surface 104, which opposes a corresponding light emitting diode element 82 and a corresponding reflecting surface 99 of the reflector 83 and onto which light is made incident, a reflecting surface 105, which reflects the light made incident from the incidence surface 104, and an exit surface 106, from which the light made incident onto the incidence surface 104 and the light reflected by the reflecting surface 105 exit. The plurality of lenses 103 are made integral and connected at the exit surface 106 sides, and a light emitting surface 107 of the lens body 84 is formed by the integral exit surfaces 106. The reflecting surface 105 of each lens 103 is isolated, and gaps 108 are formed between the external surfaces of the reflecting surfaces 105 of the respective lenses 103 so as to face the substrate 81 side, that is, the reflector 83.

With each lens 103, a ring-like bonding surface 109 that is bonded to the top surface of the reflector 83 is formed between the incidence surface 104 and the reflecting surface 105, and a protruding lens-side fitting portion 110 that fits with the corresponding reflector-side fitting portion 101 is formed in a ring-like manner on the bonding surface 109. The lens-side fitting portion 110 of the lens 103 is fitted into the reflector-side fitting portion 101 of the reflector 83 and these portions are welded by laser welding, ultrasonic welding, etc. The light emitting diode elements 82, the reflector 83, and the lenses 103 can thus be positioned accurately to stabilize the optical characteristics, and the lenses 103 can be fixed reliably onto the reflector 83. In this process, with the reflector 83 and the lenses 103, the reflector 83 melts and becomes welded and the lenses 103 do not melt so that degradation of the optical characteristics of the lenses 103 can be prevented.

Also, as shown in FIG. 15 and FIG. 16, the main device body 73 has a plate-like main body portion 121, formed of a material of high heat conductance, such as a glass epoxy resin, an engineering plastic, aluminum, aluminum nitride, etc., and the plurality of light emitting modules 72 are arrayed and positioned by the other surfaces 81b of the substrate 81 of the respective modules being joined to a positioning surface 121a, which is one surface of the main body portion 121.

At an edge portion of the positioning surface 121a of the main body portion 121 is disposed a holding portion 122, into which the inserted portion 87 of the substrate 81 of a light emittingmodule 72 is insertably and extractably inserted. This holding portion 122 has a holding member 123 that is mounted onto the edge portion of the main body portion 121, and between this holding member 123 and the main body portion 121 is formed an insertion groove 124 into and from which the inserted portion 87 can be inserted and extracted. In correspondence to the layout positions of the respective light emitting modules 72, the insertion groove 124 is provided with fitting protrusions 125 that fit with the fitting groove portions 88 of the inserted portions 87, and at the respective sides of each fitting protrusion 125, wiring boards 126 are mounted on the holding member 123 side that opposes the positioning surface 121a of the main body portion 121. A connector 127 is attached to each wiring board 126. Each connector 127 has a main connector body 128 that is attached to the corresponding wiring board 126 and a terminal tab 129, formed of an elastically deformable spring steel that is protruded from the main connector body 128 toward the positioning surface 121a of the main body portion 121. The interval between the terminal tab 129 and the positioning surface 121a of the main body portion 121 is set to be smaller than the thickness of the inserted portion 87 of the substrate 81 in the state in which the inserted portion 87 of the substrate 81 is not inserted, and in the process of inserting the inserted portion 87 of the substrate 81, the terminal tab 129 deforms elastically to allow the insertion of the inserted portion 87, and in the state in which the inserted portion 87 of the substrate 81 is inserted, the respective terminal tabs 129 press contact and become electrically connected to the respective receiving portions 93 of the inserted portion 87. The respective connectors 127 are thus arranged as feeding portions 130.

Also, by combining the illuminating device 71 with an illustrated lighting device that is connected to the feeding portions 130 of the main device body 73 and makes the light emitting diode elements 82 of the light emitting modules 72 become lit, an illuminating device is arranged.

In assembling the illuminating device 71, the other surface 81b of the substrate 81 of the light emitting module 72 is bonded to and positioned at the positioning surface 121a of the main body portion 121 of the main device body 73, the fitting groove portion 88 of the inserted portion 87 of the substrate 81 is aligned with the fitting protrusion 125 of the holding portion 122 while sliding the substrate 81 along the main body portion 121 and the inserted portion 87 of the substrate 81 is inserted into the insertion groove 124 of the holding portion 122.

In the process of inserting the inserted portion 87 of the substrate 81 into the insertion groove 124 of the holding portion 122, the inserted portion 87 contacts the terminal tabs 129 of the respective connectors 127, and when the inserted portion 87 of the substrate 81 is inserted further, the terminal tabs 129 of the respective connectors 127 deform elastically and the inserted portion 87 is enabled to be inserted to the insertion position.

By inserting the inserted portion 87 into the holding portion 122, the terminal tabs 129 of the respective connectors 127, that is, the respective feeding portions 130 can be put in press contact with and thus electrically connected to the respective receiving portions 93 of the inserted portion 87.

By thus simply positioning the other surface 81b of the substrate 81 of the light emitting module 72 at the main body portion 121 of the main device body 73 and inserting the inserted portion 87 of the substrate 81 into the holding portion 122, the light emitting module 72 can be mounted readily onto the main device body 73.

In the state in which the inserted portion 87 of the substrate 81 is inserted in the holding portion 122, the terminal tabs 129 of the respective connectors 127 press the inserted portion 87 of the substrate 81 against the main body portion 121, that is, the holding portion 122 holds the substrate 81 by pressing the substrate 81 against the main body portion 121 and puts the other surface 81b of the substrate 81 in close contact with the positioning surface 121a of the main body portion 121. By the other surface 81b of the substrate 81 thus being put in close contact with the positioning surface 121a of the main body portion 121, the light emitting module 72 can be positioned to enable stabilization of the direction of emission of the highly directional light from the light emitting diode elements 82 and improvement of the heat radiation from the substrate 81 to the main body portion 121.

By feeding electricity to the light emitting module 72 from the unillustrated lighting device and through the feeding portions 130, the plurality of light emitting diode elements 82 of the light emitting module 72 can be made to become lit.

The heat generated when the plurality of light emitting diode elements 82 are lit can be conducted efficiently to the substrate 81 of excellent heat conductance, and because the substrate 81 is in close contact with the main body portion 121, the heat of the light emitting diode elements 82 can be conducted efficiently from the substrate 81 to the main body portion 121 and the heat radiation property can be improved.

Moreover, because the insulating layer 89, interposed between the substrate 81 and the reflector 83, is arranged so that its modulus of elongation varies within 2000MPa with temperature and its thickness is no more than 75µm, good heat conductance is realized between the substrate 81 and the reflector 83, the temperature difference between the substrate 81 and the reflector 83 is reduced, and because the occurrence of a large difference in thermal expansion between the substrate 81 and the reflector 83 is thus suppressed, peeling of the substrate 81 and the reflector 83 can be prevented.

Because the reflector 83 can be put in direct close contact with the substrate 81 by making a resin flow onto the substrate 81 and molding the resin, an adhesive layer for adhering the reflector 83 by an adhesive agent is not interposed and thus the heat conductance between the substrate 81 and the reflector 83 can be made even better.

Also, because the plurality of circuit patterns 90 that connect the plurality of light emitting diode elements 82 are respectively disposed on the same area, temperature differences due to differences in the heat radiation capacity of the plurality of light emitting diode elements 82 can be lessened and the scattering of brightness among the plurality of the light emitting diode elements 82 can thereby be lessened.

Also, the heat of the plurality of the light emitting diode elements 82 is conducted to the reflector 83 and the lens body 84 and is radiated to the exterior from the reflector 83 and the lens body 84. Furthermore, because gaps 108 that face the reflector 83 are provided between the respective lenses 103 of the lens body 84, air flows through these gaps 108 and a convective flow arises due to the warm air heated by the reflector 83 and the lens 103 and the external air, thereby improving the heat radiation property.

Because the lens-side fitting portions 110 of the lenses 103 are fitted and welded to the reflector-side fitting portions 101 of the reflector 83, the light emitting diodes 82 and the reflector 83 can be aligned accurately with the lenses 103 to enable the optical characteristics to be stabilized and the lenses 103 to be fixed to the reflector 83 reliably.

Because the reflector 83 and the lenses 103 are welded by the melting of the reflector 83, the lenses 103 do not melt and degradation of the optical characteristics of the lenses 103 can be prevented.

Also, for maintenance, etc., each light emitting module 72 can be removed readily by disengaging the electrical and mechanical connection by extracting the inserted portion 87 of the substrate 81 of the light emitting module 72 from the holding portion 122 of the main device body 73.

Although with the fitting structure of the reflector-side fitting portions 101 of the reflector 83 and the lens-side fitting portions 110 of the lenses 103, the reflector-side fitting portions 101 were made recessed in form and the lens-side fitting portions 110 were made protruded in form, the same actions and effects can be obtained even if the concave and convex relationship is inverted.

### INDUSTRIAL APPLICABILITY

The present invention can be used in a fixed illumination arrangement for indoor or outdoor use, a moving body illumination arrangement for a vehicle, etc.

## Claims

1. An illuminating device comprising:
a substrate;
a circuit pattern, formed on the substrate;
a light emitting element, electrically connected to the circuit pattern;
a reflector, having a housing portion that houses the light emitting element and a reflecting surface on an inner surface of the housing portion and being adhered by an adhesive agent onto the substrate on which the circuit pattern has been formed;
a visible light converting layer, disposed on the housing portion of the reflector so as to cover the light emitting element; and
a lens, adhered onto the reflector by a same type of adhesive agent as the adhesive agent disposed on the substrate.

2. An illuminating device comprising:
a substrate;
a circuit pattern, formed on the substrate;
a light emitting element, electrically connected to the circuit pattern;
a reflector, having a housing portion that houses the light emitting element and a reflector-side fitting portion formed in a periphery of the housing portion and being formed on the substrate on which the circuit pattern has been formed; and
a visible light converting layer, disposed on the housing portion of the reflector so as to cover the light emitting element.

3. The illuminating device according to Claim 2, further comprising:
a lens, having a lens-side fitting portion that fits with the reflector-side fitting portion and is welded in a fitted state onto the reflector.

4. The illuminating device according to Claim 2 or 3, wherein
the substrate has a plurality of light emitting element positioning portions, at which a plurality of light emitting elements are positioned, and anchoring-portion-provided penetrating holes, formed between the plurality of light emitting element positioning portions, and
the reflector has reflecting portions, reflecting light from the light emitting elements and being formed on the substrate, and supporting portions, formed integral to the reflecting portions by making a resin flow into the anchoring-portion-provided penetrating holes of the substrate.

5. The illuminating device according to any one of Claims 1 to 4, wherein
the housing portion satisfies a relationship, θ = tan⁻¹{h/ (A-B) }>45°, where A is an aperture diameter at the lens side, B is an aperture diameter at the substrate side, h is a depth of the housing portion, and θ is an angle of spread of the housing portion from the substrate side to the lens side.

6. The illuminating device according to any one of Claims 1 to 5, wherein
the visible light converting layer is formed by dispersing a visible light converting substance in one type of resin among a silicone resin, an epoxy resin, and a modified epoxy resin.

7. The illuminating device according to any one of Claims 1 to 5, wherein
two resin layers are formed on the housing portion of the reflector so as to cover the light emitting element,
the visible light converting layer is the upper layer of the two resin layers and is formed by making a visible light converting substance sediment in one type of resin among a silicone resin, an epoxy resin, and a modified epoxy resin.
